# EUROPÄISCHE PATENTANMELDUNG

(11) **EP 4 601 194 A1**
(43) Veröffentlichungstag der Anmeldung: **13.08.2025**
(21) Anmeldenummer: 25152762.8
(22) Anmeldetag: 20.01.2025
(51) Int. Cl.: H03K 17/30, H01H 83/00, H02M 1/00

(54) **SCHALTER MIT ELEKTRONISCHER AUSLÖSEEINHEIT**

(30) Priorität: 09.02.2024 DE 102024201202
(71) Anmelder: Siemens Aktiengesellschaft, 80333 München (DE)
(72) Erfinder: Dietl, Helmut, 93488 Schönthal - OT Hiltersried (DE); Fischer, Andreas, 92224 Amberg (DE); Gradl, Hans, 93158 Teublitz (DE); Müllhofer, Martin, 92284 Poppenricht (DE)
(74) Vertreter: Siemens Patent Attorneys

(57) **Zusammenfassung**

Die Erfindung betrifft einen Schalter (LS) mit einer elektronische Auslöseeinheit (ETU) und einem Versorgungsschaltkreis (NT) zur Energieversorgung der elektronische Auslöseeinheit (ETU) aus einem überwachten Stromkreis. Bei dem erfindungsgemäßen Schalter ist der Versorgungsschaltkreis (NT) mit einem Linearregler (LDO) und einem Schaltregler (DCDC) gebildet. Dabei sind ist der Linearregler (LDO) und der Schaltregler (DCDC) parallelgeschaltet. Der Schaltregler (DCDC) weist einen PowerGood-Ausgang (PG/SS) und der Linearregler (LDO) einen Disable-Eingang (SHDN) auf, welche miteinander verbunden sind. Diese Anordnung ist aufwandsarm und führt beim Aufbau einer Spannungsversorgung dazu, dass die Ausgangsspannung durch den Linearregler schnell bereitgestellt wird und dieser dann über den Disable-Eingang deaktiviert wird, wenn der verlustärmer arbeitende Schaltregler in der Lage ist, die Spannungsversorgung zu gewährleisten. Die Übernahme der Versorgung durch den Schaltregler erfolgt automatisch ohne externe zusätzliche Elemente oder Signalisierung.

## Beschreibung

Die Erfindung betrifft einen Schalter mit einer elektronischen Auslöseeinheit und einem Versorgungsschaltkreis zur Energieversorgung der elektronische Auslöseeinheit aus einem überwachten Stromkreis.

In einem Stromkreis eingebrachte Leistungsschalter gewährleisten einen Schutz für den Stromkreis, der ähnlich einer Sicherung funktioniert. Der Schutz wird mittels einer Überwachung des durch einen Leiter des Stromkreises hindurchfließenden Stroms gewährleistet. Typischerweise wird dabei durch den Stromkreis ein elektrischer Strom bzw. Energiefluss zu einer Energiesenke bzw. einem Verbraucher vermittelt. Durch die Leistungsschalter werden Schutzparameter auf das Vorliegen für Bedingungen für ein Unterbrechen des Stromkreises durch ein Öffnen des Schalters (man spricht hier auch vom Auslösen des Schalters) überwacht. Derartige Schutzfunktionen betreffen in der Regel Kurzschlussstrom (Überwachung des Absolutwertes des Stroms) und Überstrom (Überwachung auf Überschreiten von Stromschwellenwerten für vorgegebene Zeitspannen). Zudem kann eine komplexeren Kriterien folgende Auslösung bei Vorliegen eines Störlichtbogen vorgesehen sein.

Die Unterbrechung erfolgt beispielsweise durch Kontakte des Leistungsschalters, die geöffnet werden. Im Unterschied zu einer Sicherung sind diese Schutzparameter bzw. Ansprechwerte bei einem Leistungsschalter einstellbar. Für die Einstellung dieser Parameter und für die Überprüfung der Auslösekriterien verfügen moderne Leistungsschalter in der Regel über eine Steuereinheit, die auch als elektronische Auslöseeinheit bzw. ETU (electronic trip unit) oder als Überstromauslöseeinheit bezeichnet wird.

Insbesondere für Niederspannungsstromkreise bzw. -netze gibt es abhängig von der Höhe des vorgesehenen elektrischen Stromes im elektrischen Stromkreis verschiedene Typen von Leistungsschaltern. Mit Leistungsschalter im Sinne der Anmeldung sind insbesondere Schalter gemeint, wie sie in Niederspannungsanlagen für Ströme von 25 bis 6300 Ampere eingesetzt werden. Spezieller werden geschlossene Leistungsschalter für Ströme von 63 bis 1600 Ampere, insbesondere von 125 bis 630 oder 1200 Ampere eingesetzt. Offene Leistungsschalter werden insbesondere für Ströme von 630 bis 6300 Ampere, spezieller von 1200 bis 6300 Ampere verwendet. Offene Leistungsschalter werden auch als Air Circuit Breaker, kurz ACB, und geschlossene Leistungsschalter als Molded Case Circuit Breaker oder Kompaktleistungsschalter, kurz MCCB, bezeichnet.

Mit Niederspannung sind Spannungen bis 1000 Volt Wechselspannung oder 1500 Volt Gleichspannung gemeint. Mit Niederspannung sind ferner Spannungen gemeint, die größer als die Kleinspannung mit Werten von 50 Volt Wechselspannung oder 120 Volt Gleichspannung sind.

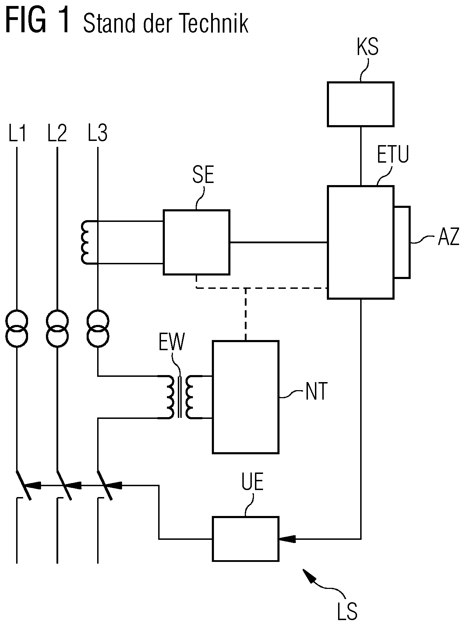

Ein Beispiel eines Leistungsschalters LS mit einer als Steuereinheit dienenden elektronischen Auslöseeinheit bzw. ETU ist in der Fig. 1 gezeigt. Der Leistungsschalter ist vorgesehen zur Unterbrechung von elektrischen Leitern L1, L2, L3 eines elektrischen Stromkreises, beispielsweise einen Dreiphasen-Wechselstromkreises, wobei der erste Leiter L1 die erste Phase, der zweite Leiter L2 die zweite Phase und der dritte Leiter L3 die dritte Phase des Dreiphasen-Wechselstromkreises bildet. Es kann ferner noch ein Neutralleiter vorgesehen sein.

Im Beispiel gemäß Fig. 1 ist der dritte Leiter L3 mit dem Energiewandler EW derart verbunden, dass mindestens ein Teil des Stromes, d.h. ein Leiterteilstrom, bzw. der gesamte Strom des dritten Leiters durch die Primärseite eines Energiewandlers EW fließt. Der Energiewandler EW ist üblicherweise ein Transformator mit Kern. Es kann auch in jeder Phase bzw. in jedem Leiter des elektrischen Stromkreises ein Energiewandler EW vorgesehen sein. Die Sekundärseite des Energiewandlers EW ist mit einem Netzteil NT verbunden, welches eine Energieversorgung, typischerweise in Form einer Versorgungsspannung, für die elektronische Auslöseeinheit ETU zur Verfügung stellt. Es ist eine Sensoreinheit SE vorgesehen, welche zur Ermittlung der Höhe des elektrischen Stromes mit mindestens einem Sensorelement gebildet ist, z.B. mit einer Rogowskispule. In einer üblichen Ausbauvariante wird die Höhe des elektrischen Stromes jedes Phasenleiters bzw. Leiters des elektrischen Stromkreises ermittelt.

Die Sensoreinheit SE ist mit der Steuerungseinheit ETU verbunden und übermittelt dieser die Höhe des elektrischen Stromes der Leiter L1-L3 des elektrischen Stromkreises.

Die übermittelten Stromwerte werden in der elektronischen Auslöseeinheit ETU mit Stromgrenzwerten oder/und Strom-Zeitspannen-Grenzwerten, die Auslösegründe bilden, verglichen. Bei Überschreitung dieser wird eine Unterbrechung des elektrischen Stromkreises veranlasst. Dies ist mittels einer Unterbrechungseinheit UE realisiert, die einerseits mit der elektronischen Auslöseeinheit ETU verbunden ist und andererseits Kontakte zur Unterbrechung der Leiter L1, L2, L3 bzw. weiterer Leiter des elektrischen Stromkreises aufweist. Die Unterbrechungseinheit UE erhält in diesem Fall ein Unterbrechungssignal zur Öffnung der Kontakte.

Die elektronische Auslöseeinheit ETU ist mit einer Anzeige AZ versehen, auf der Werte von systemrelevanten Größen angezeigt werden können, z.B. Strom, Spannung, Energie, Leistung, Phasenwinkel etc. Dabei werden diese zum Teil gemessen, zum Teil aus Messwerten berechnet. Eingezeichnet ist auch eine Kommunikationsschnittstelle KS (z.B. Zigbee, Wi-Fi oder BLE Funkschnittstelle oder Kabelschnittstelle, z.B. für LAN-Kabel), über die die erfassten systemrelevanten Werte z.B. an eine Überwachungsstelle zur Anzeige bzw. Analyse übertragen werden können.

Da die Energieversorgung der elektronische Auslöseeinheit ETU aus dem überwachten Stromkreis erfolgt, ist diese nicht aktiv, solange kein zu überwachender Strom fließt. Beim Ende dieses Ruhezustands muss die elektronische Auslöseeinheit ETU zum einen sehr schnell aufwachen und zum anderen die (begrenzt) zur Verfügung stehenden Energie effektiv umsetzen.

Aus der IN354091-B ist eine Lösung für einen Schalter bekannt, die zwei Regler (50a, 50b) verwendet, die durch eine Kontrolllogik (60) angesteuert werden, die wiederum durch einen Kontroller (90) Steuerbefehle erhält. Durch den Einsatz der Regler lässt sich die Spannungsversorgung für eine schnelles Funktionieren des Schalters beim Aufwachen aus einer Ruhephase anpassen.

Die Erfindung hat zur Aufgabe, eine aufwandsoptimierte Energieversorgung für eine ETU eines Leistungsschalters bereitzustellen, die Erfordernisse bzgl. schneller Funktionsfähigkeit in einer Aufwachphase sowie einer effizienten Energieversorgung beim Regelbetrieb berücksichtigt.

Die Aufgabe wird gelöst durch einen Schalter, z.B. einen Niederspannungs-Leistungsschalter, mit einer elektronische Auslöseeinheit und einem Versorgungsschaltkreis zur Energieversorgung der elektronische Auslöseeinheit aus einem überwachten Stromkreis. Bei diesem erfindungsgemäßen Schalter ist der Versorgungsschaltkreis mit einem linearen Spannungsregler - im Folgenden als "Linearregler" bezeichnet - und einem Schaltregler gebildet, welche zueinander parallelgeschaltet sind. Der Schaltregler weist einen PowerGood-Ausgang auf und der Linearregler einen Disable-Eingang, welche miteinander verbunden sind. In den meisten Fällen wird für die ETU eines Schalters eine Versorgungsspannung erzeugt, die niedriger als die speisende Netzspannung ist. Für die Spannungsversorgung wird dann die Netzspannung heruntergeregelt. Für diese Konstellation kann als Schaltregler beispielsweise ein Abwärtswandler bzw. Step-Down-Converter oder auch ein sog. SEPIC-Wandler (SEPIC: single ended primary inductance converter) zum Einsatz kommen. Die Erfindung ist aber auch in Szenarien anwendbar, in denen eine Höherregelung der Spannung erforderlich ist. In diesen Szenarien kann als Schaltregler z.B. auch ein Hochsteller zum Einsatz kommen.

Die erfindungsgemäße Anordnung ist aufwandsarm und führt beim Aufbau einer Spannungsversorgung dazu, dass die Ausgangsspannung durch den Linearregler schnell bereitgestellt wird und dieser dann über den Disable-Eingang deaktiviert wird, wenn der verlustärmer arbeitende Schaltregler in der Lage ist, die Spannungsversorgung zu gewährleisten. Die Übernahme der Versorgung durch den Schaltregler erfolgt automatisch ohne externe zusätzliche Elemente oder Signalisierung.

Gemäß einer Weiterbildung ist dem Ausgang des Schaltreglers eine Diode oder eine das Verhalten einer Diode nachbildende Schaltung (Schaltung vom Typ "ideale Diode") in Serie geschaltet. Auf diese Weise wird ein Einfluss von typischerweise vorhandenen ausgangsseitigen kapazitiven Elementen des Schaltreglers während der Spannungswandlung durch den Linearwandler und damit eine dadurch mögliche Verzögerung bei dem Aufbau der Zielausgangsspannung unterbunden. Eine entsprechende das Verhalten einer Diode nachbildende Schaltung, welche z.B. mit mindestens einem Schalttransistor (Mosfet etc.) gebildet ist, kann derart ausgestaltet und derart mit dem PowerGood-Ausgang des Schaltregler verbunden sein, dass sie bei Anliegen eines PowerGood-Signals leitend wird.

Gemäß einer bevorzugten Ausführungsform ist der Versorgungsschaltkreis des erfindungsgemäßen Schalters für eine Energieversorgung (typischerweise Spannungsversorgung) der elektronischen Auslöseeinheit bzw. ETU durch mittels eines Energiewandlers dem überwachten Stromkreis entnommener Energie ausgestaltet.

Der Versorgungsschaltkreis kann in Reihe geschaltet Bestand-teile zur Gleichrichtung, zur Filterung oder Glättung und zur Spannungstransformation enthalten. Dabei kann dann der Bestandteil bzw. die Stufe zur Spannungstransformation mit dem Linearregler und dem Schaltregler gebildet sein.

Im Folgenden wird die Erfindung im Rahmen eines Ausführungsbeispiels anhand von Figuren näher erläutert. Es zeigen
- Fig. 1:: einen Leistungsschalter,
- Fig. 2:: Elemente des Leistungsschalters von Fig. 1,
- Fig. 3:: einen Linearregler,
- Fig. 4:: einen Abwärtswandler,
- Fig. 5:: das Verhalten von Linearregler und Abwärtswandler beim Aufbau einer Ausgangsspannung,
- Fig. 6:: eine Parallelschaltung eines Linearreglers und eines Abwärtsreglers mit Hilfe eines Mikrokontrollers,
- Fig. 7:: den Einfluss einer Kapazität des Abwärtsreglers bei einer Konstellation entsprechend Fig. 6,
- Fig. 8:: eine erfindungsgemäße Anordnung von Linearregler und Abwärtswandler,
- Fig. 9:: Signalverläufe bei einer erfindungsgemäßen Anordnung und
- Fig. 10:: einen Schaltplan einer erfindungsgemäßen Anordnung von Linearregler und Abwärtswandler.

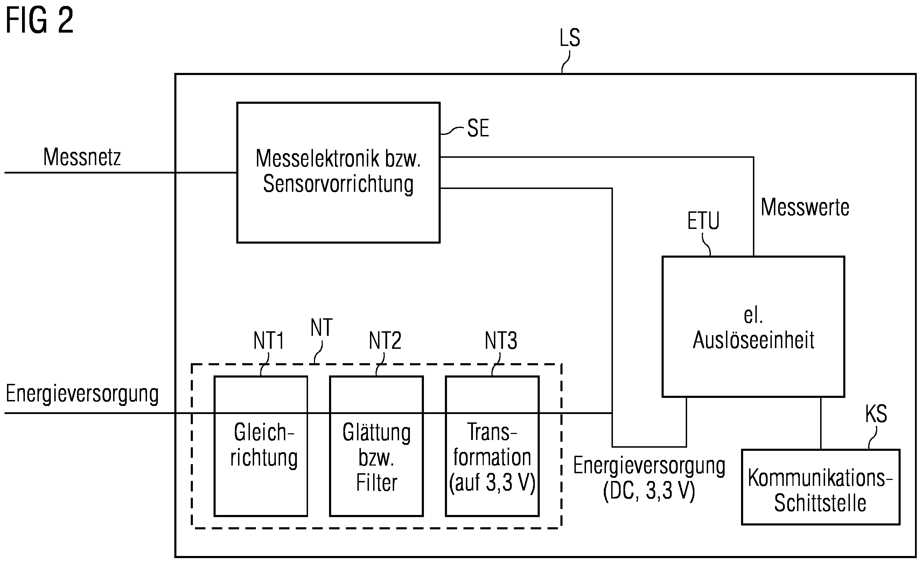

Fig. 2 zeigt Elemente des in Fig. 1 dargestellten Leistungsschalters mit einer detaillierteren Darstellung des prinzipiellen Aufbaus des Netzteils NT. Dieses ist mit drei in Serie angeordneten Bestandteilen NT1-NT3 gebildet. Typischerweise erfolgt (bei einer Speisung mit Wechselstrom) zunächst eine Gleichrichtung durch NT1, dann eine Filterung bzw. Glättung durch NT2 und schließlich eine Transformation der Spannung hinunter auf den für die ETU passenden Wert von 3,3V durch NT3.

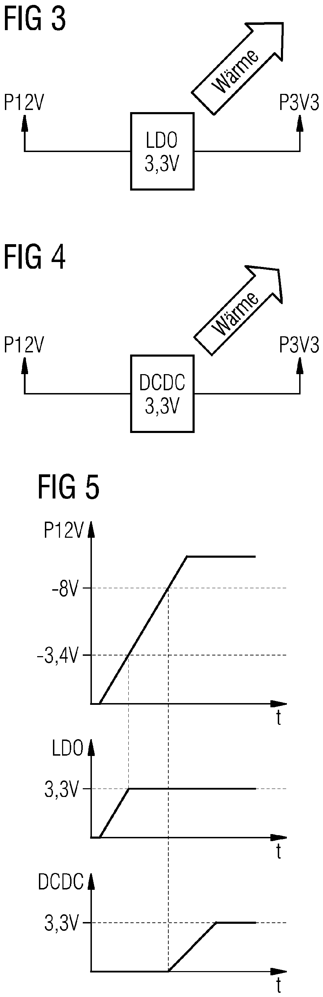

Für die Abwärtstransformation gibt es unterschiedliche Lösungen. In Fig. 3 ist ein linearer Spannungsregler - auch als LDO bzw. "Low Drop Out" bezeichnet - gezeigt, der die zur Verfügung stehende Spannung (z.B. 12V) auf die niedrigere Spannung von z.B. 3.3V herabregelt. Durch die LDO-Topologie hat man den Vorteil, dass durch den LDO bereits bei einer leicht höheren Spannung (oberhalb der gewählten Ausgangsspannung (3,3V)) sich die gewünschte Ausgangsspannung einstellt. Der Nachteil ist jedoch, dass bei größeren Eingangsspannungen die Differenz aus Eingangs- und Ausgangsspannung in Form von Wärme als Verlustleistung anfällt und damit nicht mehr für die eigentlich benötigte Ausgangsleistung zur Verfügung steht, d.h. man nimmt einen schlechten Wirkungsgrad in Kauf.

Eine andere Lösung ist ein Abwärtswandler bzw. Step-Down-Converter DCDC zur Spannungswandlung, wie er in Fig. 4 gezeigt ist. Hier liegt der wesentliche Vorteil darin, dass die zur Verfügung stehende Energie mit einem hohen Wirkungsgrad umgewandelt wird, d.h. ein sehr guter Wirkungsgrad wird erzielt.

Als Nachteil ist jedoch anzumerken, dass ein Step-Down-Converter eine wesentlich längere Zeit benötigt, um die Ausgangsspannung einzustellen, sowie eine größere Differenz zwischen Eingangs- und Ausgangsspannung erfordert.

In Fig. 5 ist das Verhalten beider Wandler für die Abwärtstransformation von einer 12V Spannung auf den von der ETU benötigten Eingangswert von 3,3 V während der Aufwachphase der ETU gezeigt. Die oberste Kurve zeigt die sich am Eingang des Wandlers aufbauende Spannung, wenn der Leistungsschalter LS aus Fig. 1 nach einer Phase, in dem der Stromkreis keinen Strom geführt hat, wieder über den Energiewandler EW mit Energie versorgt wird. Die mittlere Kurve stellt die am Ausgang eines LDOs bereitgestellte Spannung dar, die untere die am Ausgang eines Step-Down-Converters DCDC. Die Zielspannung von 3,3V wird von dem LDO erheblich schneller geliefert.

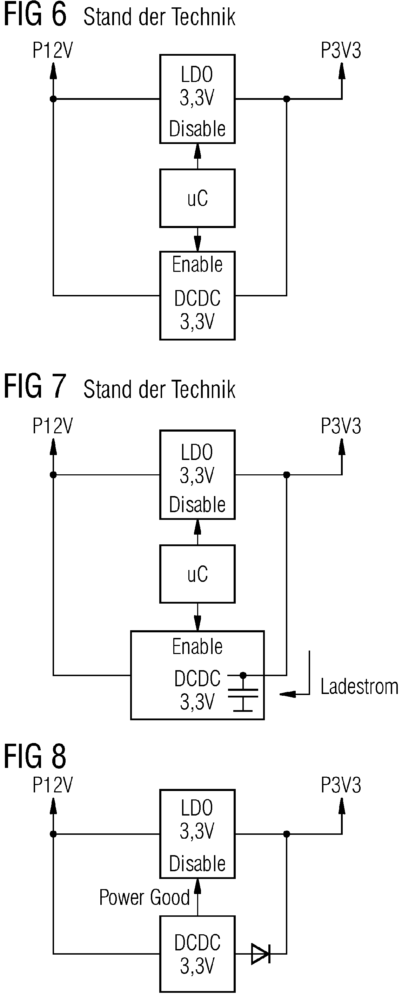

Um dem Verlustleistungsnachteil des LDOs entgegenzuwirken, wird ein Step-Down-Converter DCDC mit einem LDO kombiniert, d.h. um die Vorteile beider Wandler zu vereinen, werden der Linearregler bzw. LDO und der Step-Down-Converter DCDC parallelgeschaltet. In der Startphase soll der LDO zunächst die Ausgangspannung schnell auf den Zielwert bringen, um dann durch den Step-Down-Converter DCDC mit dem besseren Wirkungsgrad abgelöst zu werden. Die Umschaltung von LDO zu Step-Down-Converter DCDC kann durch einen Mikroprozessor uC erfolgen, wie in Fig. 6 angedeutet. Diese Lösung hat aber nicht nur den Nachteil eines relativ hohen Aufwands (zusätzlicher Mikroprozessor). Ein weiterer Nachteil besteht darin, dass der Step-Down-Converter DCDC im Ausgang einen Kondensator besitzt, welcher während des Spannungsaufbaus eine zusätzliche (kapazitive) Belastung für den LDO darstellt (vgl. Fig. 7).

Erfindungsgemäß erfolgt daher die Umschaltung nach Erreichen der Ausgangsspannung des Step-Down-Converters DCDC automatisiert durch einen PowerGood-Ausgang, welcher auf einen Disable-Eingang am LDO geführt ist. Am PowerGood-Ausgang wird ein elektrisches Signal (Power-Good-Signal) angelegt, wenn nach dem Einschwingen bzw. nach der Startphase die Ziel-Ausgangspannung in ihren Toleranzbereich erzeugt wird. Dieses Signal deaktiviert den LDO über den Disable-Eingang. Das Umschalten erfolgt dabei ohne Unterbrechung bzw. Absinken der Ausgangsspannung. Diese Lösung ist in Fig. 8 dargestellt. Es ist zudem dem Step-Down-Converter DCDC eine Diode bzw. eine die Diodenfunktion nachbildenden Schaltung nachgeschaltet, welche verhindert, dass der Kondensator im Ausgang des Step-Down-Converters DCDC während des Spannungsaufbaus durch den LDO aufgeladen wird und so den Spannungsaufbau verlangsamt.

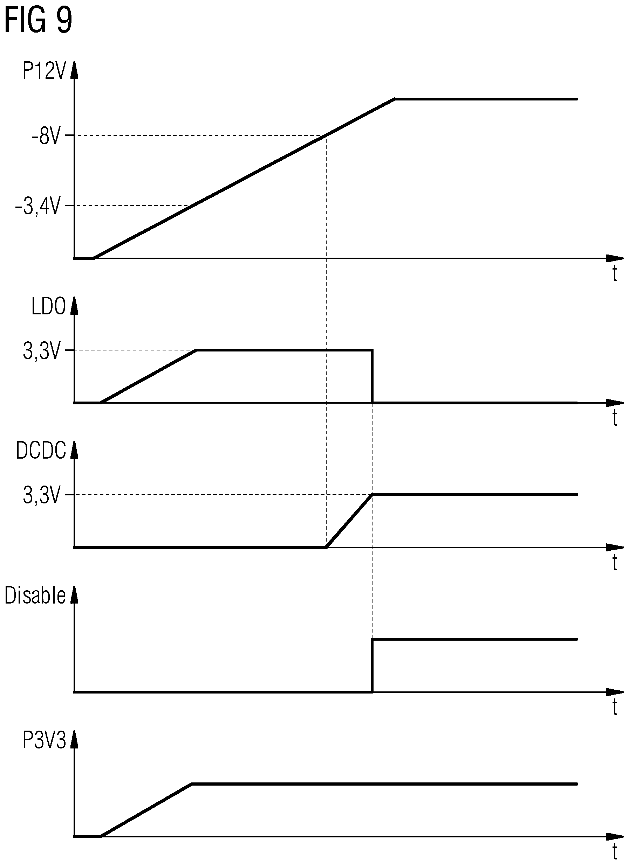

In Fig. 9 sind Signalverläufe gezeigt. Von oben nach unten sind dargestellt: die Spannung am Eingang der Wandlerparallelschaltung, die Spannung am Ausgang des LDOs, die Spannung am Ausgang des Step-Down-Converters, das Signal am PowerGood-Ausgang des Step-Down-Converters bzw. am Disable-Eingang des LDOs und die der ETU bereitgestellte Ausgangsspannung. Wie im Diagramm von Fig. 9 zu erkennen, folgt der LDO nahezu synchron der Eingangsspannung und liefert bereits nach Erreichen von -3.4V Eingangsspannung die gewünschte Ausgangsspannung von 3.3V. Ab einer Spannung von ~8V beginnt der Step-Down-Converter zu arbeiten. Sobald die gewünschte Ausgangsspannung erreicht ist, gibt dieser einen Ausschaltbefehl an den LDO, worauf der LDO die "Lieferung" einstellt. Der Step-Down-Converter übernimmt nun die 3,3V Spannungs-Generierung zur Gänze.

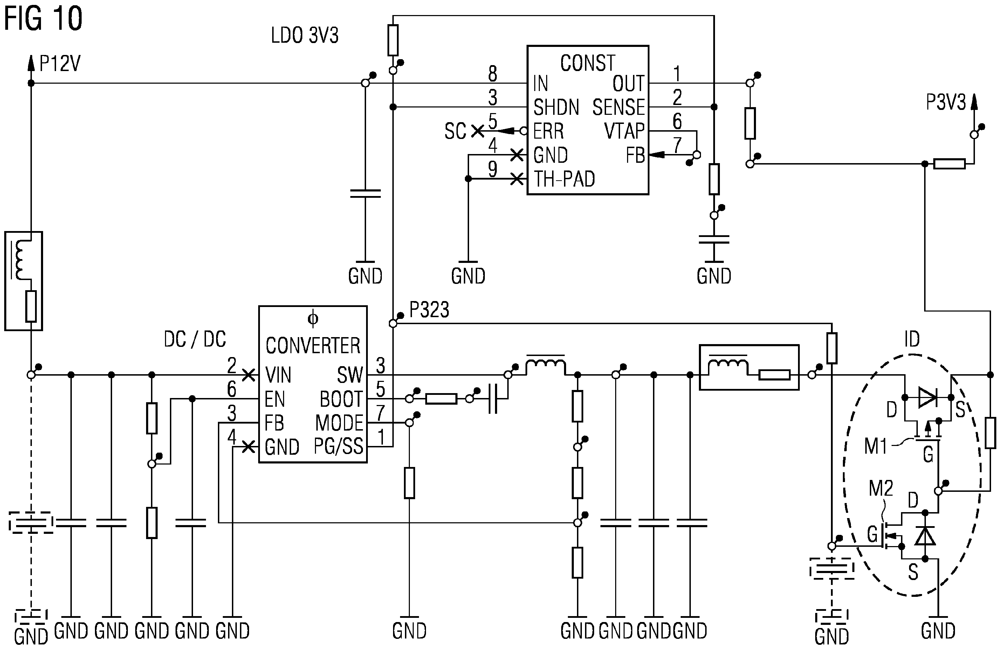

In Fig. 10 ist eine detailliertere Darstellung einer erfindungsgemäßen Parallelschaltung eines LDOs und eines Step-Down-Converters DCDC gezeigt. Der Step-Down-Converter DCDC weist einen PowerGood-Ausgang PG/SS aus, der mit einem Disable-Eingang SHDN des LDO verbunden ist. Anstelle der nachgeschalteten Diode befindet sich am Ausgang des Step-Down-Converters DCDC ein Mosfet (siehe Fig. 10), welcher eine "ideale" Diode darstellt. Diese hat zwei Aufgaben:
1. Reduzierung der Spitzenstrombelastung (Inrush current) des LDOs hervorgerufen durch die kapazitive Belastung (Ausgangskondensatoren des Step-Down-Converters DCDC) in der Phase des Spannungsaufbaus und
2. Minimierung der Durchlassverluste, wenn der Step-Down-Converter DCDC aktiv ist, wodurch eine stabile Ausgangsspannung bei unterschiedlichen Ausgangsströmen erzielt wird.

Die sog. "ideale" Diode ist eine Schaltung, welche das Verhalten einer Diode nachbildet. Derartige Schaltungen sind aus dem Stand der Technik bekannt (wobei je nach Ausführung das Verhalten mehr oder weniger "ideal" ist). In Fig. 10 ist diese ideale Diode ID mit zwei Mosfets M1 und M2 gebildet und wird mit dem PowerGood (Disable) Signal gesteuert, wofür der PowerGood-Ausgang PG/SS des Step-Down-Converters DCDC mit der Gate-Elektrode des Transistors M2 verbunden ist.

Ein wesentlicher Vorteil zu einer Lösung entsprechend Fig. 6 bzw. Fig. 7 besteht darin, dass das Umschalten ohne ein zusätzliches Element (z.B. Mikroprozessor) automatisch und ohne Notwendigkeit von Firmwarebefehlen erfolgt. Die kapazitive Belastung des LDOs beim Aufstarten ist durch die Mosfet-Schaltung reduziert.

Das Ausführungsbeispiel beschreibt nur einen speziellen Fall einer erfindungsgemäßen Lösung. Dieser ist nicht einschränkend zu interpretieren. Dem Fachmann sind zahlreiche weitere Ausgestaltungen unmittelbar einsichtig, die in den Schutzbereich der Anmeldung fallen. Beispielsweise kann als Schaltregler je nach Szenario statt einem Abwärtswandler auch ein SEPIC-Wandler oder ein Aufwärtswandler zum Einsatz kommen.

## Patentansprüche

1. Schalter (LS) mit einer elektronische Auslöseeinheit (ETU) und einem Versorgungsschaltkreis (NT) zur Energieversorgung der elektronische Auslöseeinheit (ETU) aus einem überwachten Stromkreis, bei dem
- der Versorgungsschaltkreis (NT) mit einem Linearregler (LDO) und einem Schaltregler (DCDC) gebildet ist, wobei
- der Linearregler (LDO) und der Schaltregler (DCDC) parallelgeschaltet sind,
- der Schaltregler (DCDC) einen PowerGood-Ausgang (PG/SS) aufweist,
- der Linearregler (LDO) einen Disable-Eingang (SHDN) aufweist, und
- der PowerGood-Ausgang (PG/SS) des Schaltreglers (DCDC) mit dem Disable-Eingang (SHDN) des Linearreglers (LDO) verbunden ist.

2. Schalter nach Anspruch 1,
**dadurch gekennzeichnet, dass** es sich bei dem Schaltregler (DCDC) um einen Abwärtswandler, einen SEPIC-Wandler oder um einen Aufwärtswandler handelt.

3. Schalter (LS) nach Anspruch 1 oder 2,
**dadurch gekennzeichnet, dass** dem Ausgang des Schaltreglers (DCDC) eine Diode oder eine das Verhalten einer Diode nachbildende Schaltung (ID) in Serie geschaltet ist.

4. Schalter (LS) nach Anspruch 3,
**dadurch gekennzeichnet, dass**
- dem Ausgang des Schaltreglers (DCDC) eine das Verhalten einer Diode nachbildende Schaltung (ID) in Serie geschaltet ist, und
- die das Verhalten einer Diode nachbildende Schaltung (ID) derart ausgestaltet und derart mit dem PowerGood-Ausgang (PG/SS) des Schaltregler (DCDC) verbunden ist, dass bei Anliegen eines PowerGood-Signals die das Verhalten einer Diode nachbildende Schaltung (ID) leitend wird.

5. Schalter (LS) nach Anspruch 4,
**dadurch gekennzeichnet, dass** die das Verhalten einer Diode nachbildende Schaltung (ID) mit mindestens einem Schalttransistor (M1, M2) gebildet ist.

6. Schalter (LS) nach Anspruch 5,
**dadurch gekennzeichnet, dass** der mindestens eine Schalttransistor (M1, M2) ein Mosfet ist.

7. Schalter (LS) nach einem der vorhergehenden Ansprüche,
**dadurch gekennzeichnet, dass** der Versorgungsschaltkreis (NT) für eine Energieversorgung der elektronischen Auslöseeinheit (ETU) durch mittels eines Energiewandlers (EW) dem überwachten Stromkreis entnommener Energie ausgestaltet ist.

8. Schalter (LS) nach Anspruch 7,
**dadurch gekennzeichnet, dass** der Versorgungsschaltkreis (NT) in Reihe geschaltet Bestandteile zur Gleichrichtung (NT1), zur Filterung oder Glättung (NT2) und zur Spannungstransformation (NT3) enthält.

9. Schalter (LS) nach Anspruch 8,
**dadurch gekennzeichnet, dass** der Bestandteil (Stufe) zur Spannungstransformation (NT3) mit dem Linearregler (LDO) und dem Schaltregler (DCDC) gebildet ist.

10. Schalter (NS) nach einem der vorhergehenden Ansprüche,
**dadurch gekennzeichnet, dass** es sich bei dem Schalter (NS) um einen Niederspannungs-Leistungsschalter handelt.
